# EUROPEAN PATENT SPECIFICATION

(11) **EP 2 645 660 B1**
(45) Date of publication and mention of the grant of the patent: **10.06.2015**
(21) Application number: 11843405.9
(22) Date of filing: 20.09.2011
(51) Int. Cl.: H04L 27/38, H03L 7/08, H03L 7/093, H03L 7/091, H04L 27/00

(54) **PLL CIRCUIT**
PLL-SCHALTUNG
CIRCUIT PLL

(30) Priority: 26.11.2010 JP 2010263800
(43) Date of publication of application: 02.10.2013
(73) Proprietor: NEC Corporation, Tokyo 108-8001 (JP)
(72) Inventor: SASAKI, Eisaku, Tokyo 108-8001 (JP)
(74) Representative: Glawe, Delfs, Moll
(86) International application number: PCT/JP2011/071938
(87) International publication number: WO 2012/070305

(56) References cited:
- EP-A2- 1 909 427
- WO-A1-2008/072552
- JP-A- 11 331 293
- JP-A- 2004 064 469
- JP-A- 2006 129 536
- JP-A- 2006 166 257
- US-A- 6 127 897
- US-B1- 6 542 039
- BOUGEARD S ET AL: "PERFORMANCE OPTIMIZATION OF HIGH ORDER QAM IN PRESENCE OF PHASE NOISE AND AWGN: APPLICATION TO A DECISION DIRECTED FREQUENCY SYNCHRONIZATION SYSTEM", WIRELESS PERSONAL COMMUNICATIONS, SPRINGER, DORDRECHT, NL, vol. 37, no. 1/02, 1 April 2006 (2006-04-01), pages 123-138, XP001501676, ISSN: 0929-6212, DOI: 10.1007/S11277-006-8863-X

## Description

### Technical Field

This invention relates to a digital wireless system, and more particularly, to a PLL circuit for use in a multilevel quadrature amplitude modulation (QAM) demodulator.

### Background Art

In recent years, in a digital wireless system for millimeter waves or microwaves, which is in rapidly increasing demand as a component in a mobile communication system, a multilevel quadrature amplitude modulation (QAM) scheme capable of high-capacity transmission and easy digitalization of a modulator/demodulator circuit is used as the modulation scheme.

An RF local oscillator (LO) signal, which is used for frequency conversion between an intermediate frequency (IF) signal and a radio frequency (RF) signal, has phase noise. In general, the level of the phase noise (represented by power density ratio at frequency deviated from center frequency (for example, 100 kHz offset) to power density at center frequency) becomes higher as the frequency of the LO signal becomes higher. Therefore, in a millimeter wave or microwave wireless system in which the RF frequency is several GHz to several tens of GHz, the phase noise level of the RF LO signal is very high.

The phase noise appears as phase rotation of a signal demodulated by a demodulator in QAM signal transmission. Received constellation points of the demodulated signal are offset from coordinates of their original convergent points in the phase direction at an angle corresponding to the phase noise level. Thus, a code error occurs when the deviation exceeds a threshold with respect to an adjacent constellation point.

A carrier recovery circuit in the demodulator is configured to a phase locked loop (PLL) circuit. As well known, the PLL circuit has the effect of suppressing phase noise as disturbance, but has a performance ceiling depending on conditions such as the modulation rate. Further, even when the phase noise level after suppression by the PLL circuit is the same, a required carrier-to-noise power ratio (C/N) for obtaining the same bit error rate (BER) becomes higher as the modulation level becomes higher, and hence BER characteristics are more degraded.

Reducing the phase noise level of an LO signal, however, leads to increased cost and narrows the frequency variable range of a transceiver. This is because decreasing the modulation sensitivity of a voltage-controlled oscillator (VCO) is necessary for improvement against phase noise. Therefore, the improvement on the phase noise level has a ceiling. Although the increase in transmission capacity is demanded by increasing the modulation level, the phase noise level tends to be higher because of the reduction in cost and the enlargement in frequency variable range.

Further, a higher-gain error correction code has now been applied to the improvement on a received field threshold (value of reception level for obtaining standard BER (for example, 1E-6)) as a performance index of a wireless device or the application of an ultra-multilevel modulation scheme exceeding 256 values. Conventionally, Reed-Solomon (RS) codes having a coding gain of about 4 dB have been typically used as error correction codes. In recent years, however, low-density parity-check codes (LDPC codes) having a coding gain higher than the RS codes by 2 dB to 4 dB have now been applied as error correction codes. Note that the LDPC code is one of the error correction codes and is one method for communicating a message through a noisy communication channel.

Phase noise of a local oscillator (LO) signal is a large constraint condition on the application of the multilevel QAM scheme having high frequency use efficiency to a system having a high RF frequency. Thus, a carrier recovery circuit with a higher phase noise suppression effect has been sought after. The first problem is that the suppression effect needs to be enhanced because the phase noise level is high.

Because of the application of error correction codes having a high coding rate, it has been required that a demodulator stably operate even at a C/N lower by, for example, 8 dB or more than a C/N ideal value at which BER without error correction is 1E-6. Such a low C/N value is a value at which BER before error correction is worse than 1E-2, which is conventionally completely out of guarantee of operation. The second problem is that there is an adverse influence on the stable operation in a low C/N environment.

Both in carrier recovery and in clock synchronization which are main signal processing performed in a demodulator, information to be extracted is not explicitly transmitted from the transmission side. It is therefore necessary to recover the carrier and clock signals based on a result of demodulating a received signal and synchronize the recovered carrier to the frequency and phase on the transmission side. This control is therefore affected by BER characteristics at the time of demodulation or noise superimposed on constellation points.

First, the problem in carrier recovery is described. The degradation becomes larger at a lower C/N. When C/N decreases, an optimum bandwidth decreases. In the range of the conventional error correction effect, the changes in optimum bandwidth and degradation depending on C/N are not so much a problem. However, in the case of using a multilevel QAM having more severe BER characteristics or using high-gain error correction, there are adverse influences on the stable operation of the demodulator and the BER improving effect by error correction.

Next, the problem in clock synchronization is described. A well-known clock synchronization circuit comprises an A/D converter for sampling a demodulated baseband signal at a frequency twice as high as the modulation rate, a phase error detector, a loop filter, and a voltage-controlled oscillator for producing a sampling clock signal. At a low C/N, the accuracy of phase error information is reduced. This is responsible for fluctuations in clock phase control, resulting in increased clock jitter. As a result, the time ratio of sampling at a phase deviated from an eye pattern opening is increased, and BER characteristics are degraded particularly in multilevel QAM. Improving the BER characteristics at a low C/N requires narrowing the bandwidth B of the PLL circuit as much as possible in order to reduce jitter. On the other hand, the bandwidth B needs to be increased to some extent in view of the overall system.

In the case of clock synchronization, a signal source on the transmission side to be synchronized is usually a crystal oscillator, where the frequency and phase are stable. However, from the mutual bandwidth relationship among a plurality of PLL circuits for clock rate conversion arranged on the transmission side or on the downstream of the demodulator on the reception side, the bandwidth of only a PLL circuit for clock synchronization in the demodulator cannot be narrowed. It is therefore necessary to operate the PLL circuit at a low C/N while ensuring a minimum bandwidth.

A clock synchronization circuit in a demodulator of a multi-level QAM system is known from US patent US 6127897.

As described above, both in the carrier recovery and in the clock synchronization, the optimum value of the bandwidth B of the PLL circuit is determined in view of both the elements of enlarging and narrowing the bandwidth B. In recent years, conditions that make it difficult to achieve both the elements have been required, and it has been difficult to determine the optimum value. This problem is unavoidable in the case where a well-known, basic PLL circuit is operated under a wide bandwidth and low C/N environment.

The prior art documents relating to this invention are known.

For example, Japanese Patent No. 4408446 (hereinafter referred to as "Patent Literature 1") discloses a method of transmitting and receiving a QAM signal at a low signal-to-noise ratio. In Patent Literature 1, from signals Cos(ω_{IF}t+ωₜt/4k) and Cos(ω_{IF}t-ωₜt/4k) present in the input spectrum, a signal of clock frequency fₜ/k and signals Cos(ωₜt/4k) and Sin(ωₜt/4k) are extracted with the help of a first system PLL (phase locked loop), and signals Cosω_{IF}t and Sinω_{IF}t are extracted with the help of a second system PLL (phase locked loop). The first system PLL comprises a control signal generator of the clock frequency fₜ/k, a generator for generating the signal Cos(ωₜt/4k) (where ωₜ=2πfₜ) from the clock frequency signal fₜ/k, a phase rotator for shifting the phase of the signal Cos(ωₜt/4k) by (-π/2) so as to obtain the signal Sin(ωₜt/4k), a multiplier for multiplying a first channel signal from a filter output by the signal Sin(ωₜt/4k), and a loop filter for extracting the clock frequency signal fₜ/k and the signals (ωₜt/4k) and Sin(ωₜt/4k) from the output signal of the multiplier. The second system PLL comprises a signal generator controlled by a frequency of the signal Cosω_{IF}t, a phase rotator for shifting the phase of the signal Cosω_{IF}t by (-π/2) so as to obtain the signal Sinω_{IF}t, a multiplier for multiplying the signal Sinω_{IF}t by an intermediate frequency input signal to generate a second channel, a filter having a passband edge of fₜ/4k for optimum filtering of the second channel, a multiplier for multiplying a second channel signal as the output from the filter by the signal Cos(ωₜt/4k), and a loop filter for extracting the signals Cosω_{IF}t and Sinω_{IF}t from the output of the multiplier.

Further, Japanese Unexamined Patent Application Publication (JP-A) No. 7-193609 (hereinafter referred to as "Patent Literature 2") discloses a "digital phase synchronization loop circuit", which is capable of stabilizing the operation in a synchronization established state and sufficiently absorbing phase jitter generated in an RF frequency converter, thereby reducing a data error rate. The digital phase synchronization loop circuit disclosed in Patent Literature 2 is applied to a carrier recovery circuit for recovering a stable carrier. The digital phase synchronization loop circuit comprises a complex multiplexer for performing complex multiplication between a complex signal and a carrier to produce a complex multiplication signal, a phase comparator for detecting a phase error from the complex multiplication signal based on phase comparison characteristics, a limiter for controlling an output of the phase error, a synchronization determination circuit for determining a synchronization state based on the output of the phase error, a C/N determination circuit for determining a C/N value based on the complex multiplication signal, a selector for selectively deriving a phase error signal from the phase comparator or from the limiter based on the synchronization state or the C/N value, a loop filter for smoothing an output of the selector to produce a control signal, a numerically-controlled oscillator for producing a phase signal whose oscillation frequency is controlled based on the control signal, and a data converter for producing the carrier based on the phase signal. The phase comparator obtains TAN characteristics by using the complex multiplication signal of the real and imaginary parts supplied from the complex multiplexer, and detects the phase based on inverse characteristics (TAN⁻¹) thereof.

Next, the problems in Patent Literature 1 and Patent Literature 2 are described.

Patent Literature 1 describes only the characteristics improvement of the carrier recovery circuit at a low C/N. Patent Literature 1 has no description on the characteristics improvement in clock synchronization. The method of Patent Literature 1 cannot be applied to the clock synchronization in principle. Also for carrier recovery, the method of Patent Literature 1 has the following problems. (1) An additional circuit is necessary also on the transmission side. (2) Processing on the demodulator side is formed of an analog stage before A/D conversion, which is not suitable for a device having a highly-digitized circuit.

Also Patent Literature 2 is limited to the carrier phase synchronization. In Patent Literature 2, it is necessary to switch the presence/absence of the limiter depending on the synchronization state or the C/N value. Therefore, in Patent Literature 2, the synchronization determination circuit or the C/N determination circuit, and the selector are necessary, leading to a problem of a complicated configuration. Patent Literature 2 has another problem in that a complicated operation (calculation) is necessary because the phase comparator (phase error detection means) detects the phase by the inverse characteristics of TAN.

### Disclosure of the Invention

It is an object of this invention to enable two PLL circuits (carrier recovery and clock synchronization) used in a demodulator to stably operate at a C/N lower by 4 dB or more than conventional while ensuring a wide bandwidth B.

According to this invention, there is provided a PLL circuit used as a clock synchronization circuit according to claim 1.

According to this invention, the carrier recovery and the clock synchronization among the functions of the demodulator can be stably operated even at a low C/N value.

### Brief Description of the Drawing

Fig. 1 is a block diagram illustrating a carrier synchronization circuit (PLL circuit);
Fig. 2 is a graph showing a process of determining an optimum bandwidth of the PLL circuit;
Fig. 3 is a graph showing noise-frequency characteristics generated in a PLL circuit in which a received signal subjected to thermal noise is an information source;
Fig. 4 is a graph (only the first quadrant of 16QAM) showing a change in PD output range caused by a limiter circuit used in the carrier synchronization circuit illustrated in Fig. 1;
Fig. 5 is a graph showing input/output characteristics of a phase error detector (PD) used in the PLL circuit illustrated in Fig. 1;
Fig. 6 is a probability density distribution chart of an output of a limiter circuit (LIMIT) used in the PLL circuit illustrated in Fig. 1;
Fig. 7 is a graph showing the relationship between a limit value and a C/N improvement;
Fig. 8 is a graph showing the relationship between a limit value and a PD gain;
Fig. 9 is a graph showing a limit value and an overall improvement;
Fig. 10 is a block diagram illustrating a clock synchronization circuit (PLL circuit) according to an embodiment of this invention; and
Fig. 11 is a graph showing the relationship between an eye pattern and a sampling phase, for describing the principle of the clock synchronization circuit.

### Mode for Embodying the Invention

In order to facilitate the understanding of this invention, the prior art and its problems are first described in detail. Note that, the prior art mentioned herein is the well-known, most basic PLL circuit. This is because there is no other well-known technology effective both for carrier recovery and for clock synchronization than the most basic PLL circuit.

As described above, both in carrier recovery and in clock synchronization which are main signal processing performed in a demodulator, information to be extracted is not explicitly transmitted from the transmission side. It is therefore necessary to recover the carrier and clock signals based on a result of demodulating a received signal and synchronize the recovered carrier to the frequency and phase on the transmission side. This control is thus affected by BER characteristics at the time of demodulation or by noise superimposed on constellation points.

The influence is described below.

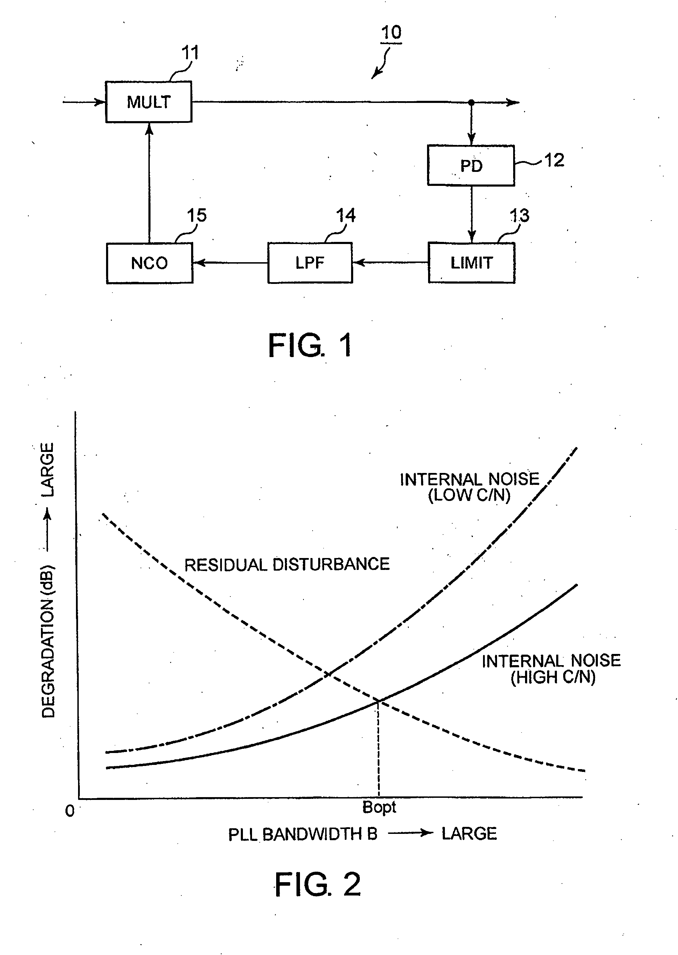

Referring to Fig. 2, the problem in carrier recovery is first described. In Fig. 2, the abscissa represents a PLL bandwidth B and the ordinate represents a logarithmic expression of degradation. A carrier recovery circuit is required to suppress phase noise of an RF LO signal, and the upper limit of a suppressible frequency is determined by the bandwidth B of the PLL circuit. The PLL circuit acts as a high pass filter (HPF) having a cutoff frequency equal to the bandwidth B against the phase noise. Thus, the degradation by phase noise becomes smaller as the bandwidth B of the PLL circuit becomes wider (downward sloping curve of Fig. 2).

On the other hand, demodulated signal point coordinates as an information source for phase control are subjected to phase noise as well as thermal noise in a transmission line, and the thermal noise appears in a PLL control signal. The PLL circuit acts as a low pass filter (LPF) against the thermal noise, and hence when the bandwidth B is increased, the suppression of thermal noise becomes smaller (upward sloping curve of Fig. 2). The degradation by thermal noise is larger at a lower C/N.

The bandwidth B of the PLL circuit is selected so that the characteristics improving effect produced by the phase noise suppression by the PLL circuit and the effect of preventing characteristics degradation caused by noise generated from inside the PLL circuit are both maximum. However, when C/N decreases, an optimum bandwidth Bopt decreases. In the range of the conventional error correction effect, the changes in optimum bandwidth Bopt and degradation depending on C/N are not so much a problem. However, in the case of using a multilevel QAM having more severe BER characteristics or using high-gain error correction, there are adverse influences on the stable operation of the demodulator and the BER improving effect by error correction.

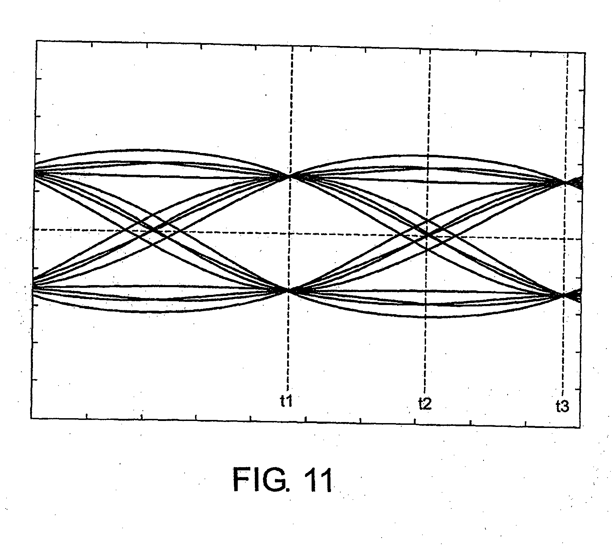

Referring to Fig. 11, the problem in clock synchronization is next described. Some algorithms are available to extract phase error information in clock synchronization, but the following description presupposes a zero-crossing detection method.

A PLL circuit for clock synchronization comprises an A/D converter for sampling a demodulated baseband signal at a frequency twice as high as the modulation rate, a phase error detector, a loop filter, and a voltage-controlled oscillator VCO for producing a sampling clock signal.

Fig. 11 is an eye pattern in QPSK, where the sampling phase at the frequency twice as high as the modulation rate is represented by t1, t2, and t3. When the polarities at t1 and t3 are opposite to each other, the signal zero-crosses (changes from + to - or from - to +) at t2 therebetween, and hence lead/lag information of the sampling phase can be obtained from the value of the signal at t2. At a low C/N, an identification error occurs also in the polarity at t2 to reduce the accuracy of phase error information. This is responsible for fluctuations in clock phase control, resulting in increased clock jitter. As a result, the time ratio of sampling at a phase deviated from an eye pattern opening is increased, and BER characteristics are degraded particularly in multilevel QAM. Improving the BER characteristics at a low C/N requires narrowing the bandwidth B of the PLL circuit as much as possible in order to reduce jitter. On the other hand, the bandwidth B needs to be increased to some extent in view of the overall system.

In the case of clock synchronization, a signal source on the transmission side to be synchronized is usually a crystal oscillator, where the frequency and phase are stable. However, from the mutual bandwidth relationship among a plurality of PLL circuits for clock rate conversion arranged on the transmission side or on the downstream of the demodulator on the reception side, the bandwidth of only a PLL circuit for clock synchronization in the demodulator cannot be narrowed. It is therefore necessary to stably operate the PLL circuit at a low C/N while ensuring a minimum bandwidth.

A phase locked loop (PLL) circuit for extracting, by a phase error detector, phase error information from a signal in which a variance of a phase or an amplitude changes depending on a signal-to-noise power ratio (typically represented by S/N; in a wireless communication system, a carrier-to-noise power ratio C/N is used), and providing negative feedback control, to thereby suppress a phase error of the signal. The PLL circuit comprises the phase error detector for producing a phase error signal corresponding to a value of the phase error as the phase error information, a limiter circuit for limiting an output range of the phase error signal to a constant value or less to produce the limited phase error signal, and a loop filter for producing a control signal based on the limited phase error signal to determine frequency characteristics of a loop.

Specific applied circuits are a carrier recovery circuit and a clock synchronization circuit in a multilevel QAM demodulator in a digital wireless communication system. The limiter circuit limits a signal expression range of the phase error signal which is the output of the phase error detector (phase detector (PD)). Thus, the amount of noise generated in the PLL circuit is reduced to suppress carrier jitter or clock jitter, thus improving bit error rate (BER) characteristics at a significantly low carrier-to-noise power ratio (C/N).

Next, the configuration of exemplary embodiments of this invention is described with reference to the drawings.

Fig. 1 is a block diagram illustrating an exemplary configuration of a carrier recovery circuit 10 to which a PLL circuit is applied.

The illustrated carrier recovery circuit 10 comprises a complex multiplexer (MULT) 11, a phase error detector (PD) 12, a limiter circuit (LIMIT) 13, a loop filter (LPF) 14, and a numerically-controlled oscillator (NCO) 15.

The phase error detector 12 extracts carrier phase error information from point coordinates of a demodulated received signal output from the complex multiplexer 11, and supplies a phase error signal representing the extracted carrier phase error information to the limiter circuit 13. The phase error detector 12 produces a phase error signal corresponding to a value of a carrier phase error as the carrier phase error information. The limiter circuit 13 limits the amplitude of the phase error signal which is an output signal of the phase error detector 12 to produce the limited phase error signal.

The loop filter 14 is supplied with the limited phase error signal output from the limiter circuit 13, and performs an operation of providing frequency characteristics of a carrier recovery loop to produce a carrier phase control signal.

The numerically-controlled oscillator 15 is supplied with the carrier phase control signal output from the loop filter 14, and integrates the signal to be converted into phase information to produce a sine wave and a cosine wave corresponding to the phase (corresponding to a carrier of a digital signal).

The complex multiplexer 11 multiplies the demodulated received signal with complex expression, whose carrier phase is still rotating, by the complex carrier output from the numerically-controlled oscillator 15, to thereby remove residual phase rotation and establish carrier synchronization.

Next, the operation of the carrier recovery circuit illustrated in Fig. 1 is described with reference to the drawings. QAM constellation points are arranged in a square lattice. In demodulation, first, a DC offset and an amplitude gain are controlled so that each received constellation point may be put on a preset lattice. This control is well known to a person skilled in the art and has no direct relation to this invention, and hence its detailed configuration is omitted.

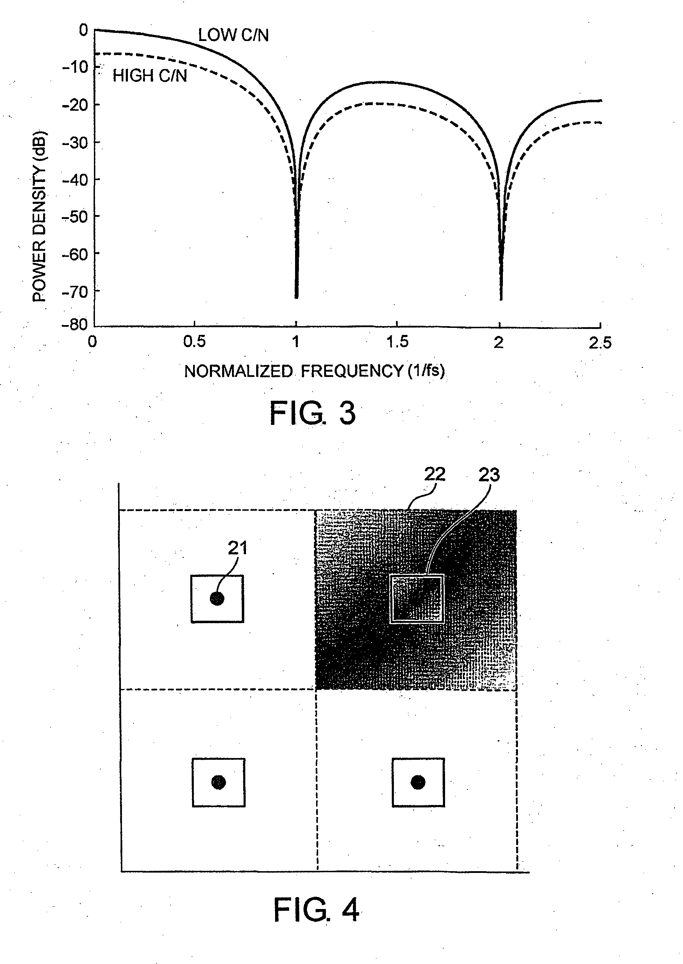

Fig. 4 exemplifies the relationship between input and output ranges of the phase error detector 12 in the first quadrant in 16QAM. The other quadrants are rotationally symmetric to the region in the first quadrant, and similar region setting is performed also in a higher-level modulation scheme.

The hatched region of Fig. 4 represents a phase error detection region for one constellation point. All constellation points are usually used as a phase error information source, but it is not always necessary to use all constellation points. A straight line connecting a constellation point and the origin is a phase lead/lag boundary. The absolute value of a phase error becomes larger as the distance from the boundary becomes larger. The phase error detector 12 sets the regions as described above to detect a carrier phase error.

Noise power generated from inside the PLL circuit, which is responsible for degradation in the carrier recovery circuit, is represented by the product of the bandwidth B of the PLL circuit and the noise power density. In this case, the bandwidth B is determined as a value necessary for suppressing phase noise so that the BER degradation becomes sufficiently small. The noise power density, on the other hand, depends on the degree of spread of received constellation points. In other words, the noise power density is a function of the C/N value, which is determined when the C/N value at which the demodulator is operated is determined. Therefore, when environmental conditions are determined, the optimum bandwidth of the PLL circuit and overall characteristics thereof are determined.

Coordinates of demodulated received constellation points change at every clock period with a modulation rate fs. The change results from thermal noise and is therefore random, except when the phase noise level is excessively large. Therefore, frequency characteristics of noise power that flows into the PLL circuit when the coordinates of the demodulated received constellation points are varied have the form of (sin x/x)² as shown in Fig. 3. In Fig. 3, the abscissa represents frequency and the ordinate represents power density. The bandwidth B of the PLL circuit of interest is sufficiently smaller than the modulation rate fs, and hence the noise power density can be regarded as constant in the range where the frequency is 0 to B. Therefore, the noise power is "noise density * B".

Consider the use of a code having a very high gain, such as an LDPC code, for error correction. In this case, the gain can be 8 dB or more, and noise power density of an input signal of the phase error detector 12 becomes very high, with the result that BER characteristics after error correction are significantly degraded.

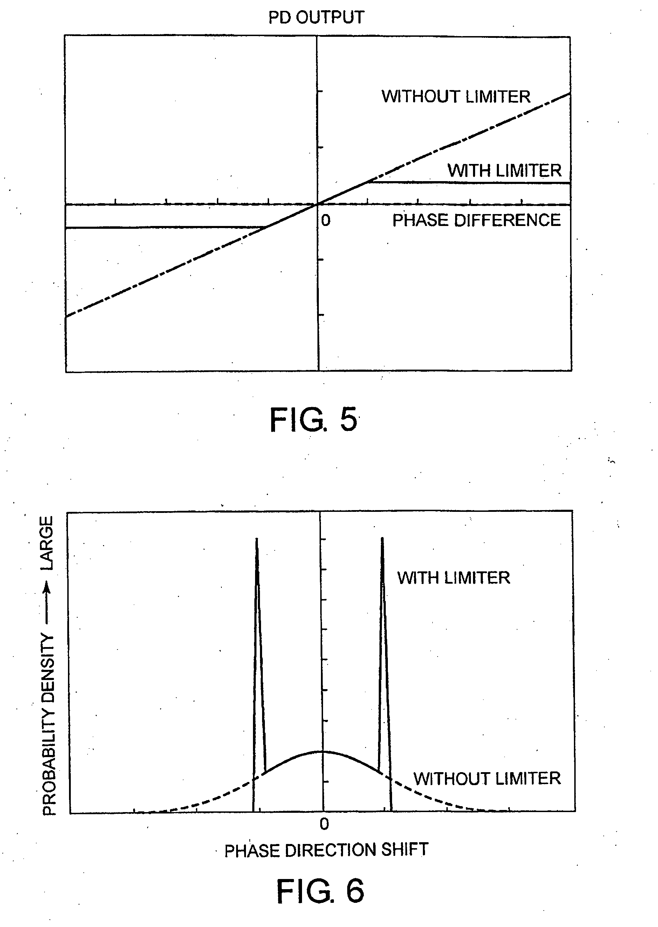

The output range of the phase error detector 12 in the carrier recovery circuit 10 is set so that the phase error detector 12 produces a larger value as a larger phase error occurs in a region of a constellation point to be determined. On the other hand, the limiter circuit 13 produces the same signal as conventional one only for a region in the immediate vicinity of the constellation point to be determined, and, when a demodulated received constellation point comes out of the region, the output of the phase error detector 12 is fixed to a border of the region. Probability density distribution of the value of the phase error signal changes depending on the presence/absence of the limiter circuit 13 as shown in Fig. 6.

The probability density is normally distributed in the case of the conventional PLL circuit without a limiter (broken line), but the presence of a limiter (solid line) limits the distribution to a certain amplitude range. Values equal to or more than the limit value are suppressed to the limit value, and as a result, the density at the limit value on the positive and negative sides becomes very high. Noise power is given by an integrated value of "square of amplitude * probability density", and hence noise power observed when no large amplitude signal is present is reduced by the limiter circuit 13 as compared with the case without a limiter. In other words, noise power flowing into the loop filter 14 becomes still lower than a value determined based on an actual C/N value.

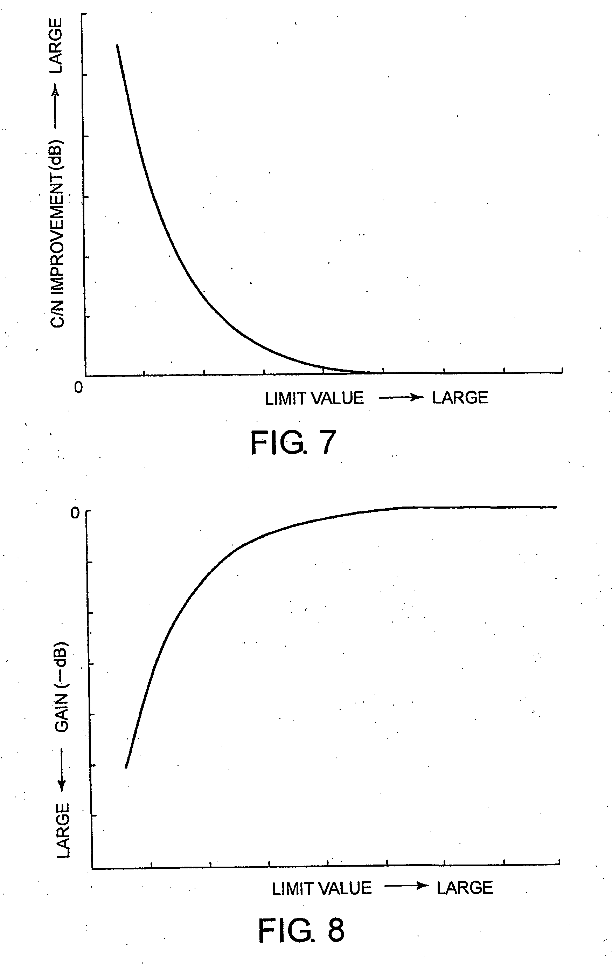

As a result, a recovered carrier signal has a smaller jitter than in the conventional case where the output of the phase error detector 12 is not limited. Fig. 7 shows the relationship between the limiter value and the decrease in noise power. This is a positive influence.

On the other hand, if the amplitude of the output signal of the phase error detector 12 is limited, input/output characteristics of the phase error detector 12 are changed as shown in Fig. 5. The gain of the phase error detector 12 is an inclination of the input/output characteristics thereof, and hence the gain is 0 in the range where the inclination is 0. The gain averaged at a large number of constellation points spreading out in a wide range is determined by "(original gain) * (probability that the inclination falls within a given range)". This is because the gain is 0 in the range where the inclination is 0 and hence the gain is 0 regardless of the probability. In other words, the gain becomes lower along with the reduction in C/N as compared with the case where no limitation is put. The gain of the phase error detector 12 becomes directly the gain of the overall loop. Therefore, when C/N reduces because of the limitation, the bandwidth of the PLL circuit is narrowed along with the reduction in loop gain. Fig. 8 shows this state.

However, phase noise suppression characteristics are degraded unless the same bandwidth B as that of the original value is ensured even at a low C/N. It is therefore necessary to change a parameter of the loop filter 14 for compensating for the decreased bandwidth B. In other words, the bandwidth B needs to be increased. The resultant increase in noise power is a negative influence.

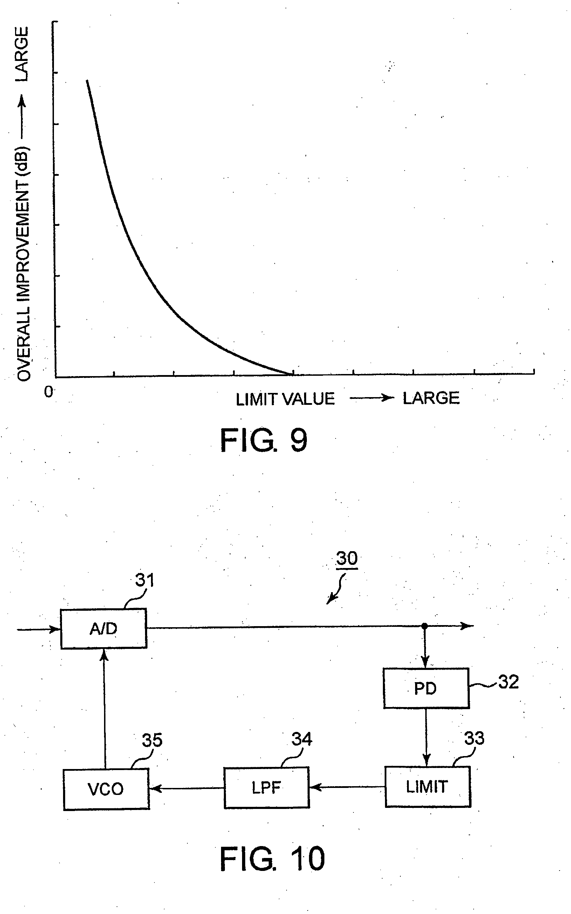

In the two positive and negative influences described above, the positive effect is always larger as shown in Fig. 9. This is because the noise power is based on a value obtained by multiplying the square of amplitude by the probability density, whereas the reduction in loop gain is based on a value obtained by multiplying the amplitude by the probability density. Thus, the power reduction effect is always larger.

Therefore, as compared with the conventional case where only a typical PLL circuit is used, the carrier recovery circuit 10 using the PLL circuit according to the first exemplary embodiment of this invention is capable of reducing noise power that flows into the PLL circuit 10 at a low C/N by providing an appropriate limitation. As a result, carrier jitter can be suppressed while the same phase noise suppression effect is maintained.

Next, description is given of the reason why the carrier recovery circuit 10 according to the first exemplary embodiment does not need to switch the presence/absence of the limiter although the switching of the presence/absence of the limiter is necessary in Patent Literature 2.

The influence by the interposed limiter circuit 13 is the reduction in PD gain caused by the fact that the output of the phase error detector (PD) 12 is not changed for some signals having a large amplitude. The reduced gain is compensated for as a gain of the entire loop by increasing the coefficient of the loop filter (LPF) 14. In this case, if C/N is high and the degree of convergence of constellation points is high, the gain may become larger than that in the case of the PLL circuit without the limiter circuit 13. However, this influence is only that the noise amount is slightly increased because the loop bandwidth becomes wider than necessary. The case considered here is the state of high C/N and good BER, and hence the increase in noise amount is at a level that is negligible by the error correction effect.

At a low C/N, on the other hand, the loop gain of the carrier recovery circuit 10 is the same as that of the PLL circuit without the limiter circuit 13, and hence there is no adverse influence.

As described above, the disadvantage of the PLL circuit 10 with the limiter circuit 13 to the PLL circuit without the limiter circuit 13 can be eliminated. As a result, the carrier recovery circuit 10 according to the first exemplary embodiment does not need to switch the presence/absence of the limiter.

On the other hand, Patent Literature 2 has no description on the reduction in gain by the limiter and its compensation, and hence the gain is changed depending on the presence/absence of the limiter. If the limiter is interposed in this state, the gain is reduced as compared with the case without a limiter, resulting in an adverse influence such as the reduction in frequency range allowing synchronization with the carrier.

Subsequently, the difference in configuration (characteristics) between the phase comparator used in Patent Literature 2 and the phase error detector (PD) 12 used in the exemple is described in detail.

First, the configuration (characteristics) of the phase comparator used in Patent Literature 2 is described. In order to detect a phase error by using the inverse tangent, it is necessary to first calculate y/x from two-dimensional information on the x coordinate (abscissa) and the y coordinate (ordinate) and further calculate the inverse tangent. However, hardware is difficult to execute division. A method of storing y/x as data by a memory using addresses of x and y is conceivable, but the memory size is significantly increased in the case where high accuracy of phase error information is needed. Thus, this method is not typically used, except for the case where the signal rate is low enough to be processed by a digital signal processor (DSP).

Next, the configuration (characteristics) of the phase error detector (PD) 12 is described.

The following method is typically used.

First, it is presupposed that the phase error detector (PD) 12 has the function of controlling the DC level (vertical and horizontal shift) and amplitude of a demodulated signal so that the demodulated signal may match with specified coordinates when the carrier is synchronous, and that the function normally operates. The phase error detector (PD) 12 is configured to produce a phase error signal corresponding to the degree and direction of the shift between the specified coordinates and the coordinates of the demodulated signal. The phase error signal can be produced by a very simple and small logic circuit based on a value determined by subtracting the specified coordinates from the coordinates of the demodulated signal (in the case of the QAM modulation scheme, the value is determined independently for two directions). The phase error detector (PD) 12 can therefore be realized easily even for a very high-speed signal. Although depending on the modulation scheme, the PD can almost share the circuit in QAM even when the modulation level is different.

The clock synchronization circuit is different from the carrier recovery circuit in component, but is completely the same as the carrier recovery circuit in the sense of being a PLL circuit for extracting phase error information from a signal subjected to thermal noise.

Fig. 10 is a block diagram illustrating an exemplary configuration of a clock synchronization circuit 30 to which a PLL circuit according to an embodiment of this invention is applied.

The illustrated clock synchronization circuit 30 comprises an A/D converter (A/D) 31, a phase error detector (PD) 32, a limiter circuit (LIMIT) 33, a loop filter (LPF) 34, and a voltage-controlled oscillator (VCO) 35.

The voltage-controlled oscillator 35 produces a sampling clock signal in response to a control signal which will be described later. The sampling clock signal has a sampling clock frequency twice as high as the modulation rate.

The A/D converter 31 is supplied with an analog baseband signal (demodulated baseband signal) from a quadrature demodulator (not shown). The A/D converter 31 converts the demodulated baseband signal into a digital signal in synchronization with the sampling clock signal.

The phase error detector 32, whose configuration and operation are different by depending on a control algorithm, produces a phase error signal corresponding to a phase error between an optimum sampling phase of the input signal of the A/D converter 31 and the sampling clock signal based on the sampled digital signal. In other words, the phase error detector 32 produces a phase error signal corresponding to the phase error as shown in Fig. 5.

The phase error signal is supplied to the voltage-controlled oscillator 35 via the limiter circuit 33 and the loop filter 34 that determines control characteristics. In other words, the loop filter 34 supplies the above-mentioned control signal for determining the control characteristics to the voltage-controlled oscillator 35 in response to the phase error signal limited by the limiter circuit 33. In this way, the phase of the sampling clock signal which is the output of the voltage-controlled oscillator 35 is controlled to match with an optimum phase.

With the above-mentioned limiter circuit 33 added to the output of the phase error detector 32 in this way in a well-known clock synchronization circuit, clock jitter at a low C/N can be suppressed.

Note that Fig. 11 shows an exemplary temporal waveform of the analog baseband signal (demodulated baseband signal).

As described above, according to the exemplary embodiment of this invention, the carrier recovery and the clock synchronization among the functions of the demodulator can be stably operated even at a low C/N value. The following effects are therefore obtained.

The first effect is that it becomes possible to apply an ultra-multilevel modulation scheme, which cannot conventionally be applied because of disadvantages of high phase noise level and large clock jitter, and hence the transmission capacity can be increased without enlarging the bandwidth.

The second effect is that, in a system aimed at improving BER characteristics at a low C/N through application of a high-gain error correction code, the performance of the error correction code can be made full use of.

The third effect is that demodulation characteristics can be improved simply by adding a very small circuit into a digital PLL circuit of a demodulator. Therefore, in the case where the demodulator is realized by a field programmable gate array (FPGA), this invention can be applied also to a device previously shipped by rewrite of the circuit. The influence on cost and power consumption is almost 0.

While the invention has been particularly shown and described with reference to exemplary embodiments thereof, this invention is not limited to the above-mentioned embodiments. It will be understood by those of ordinary skilled in the art that various changes in form and details may be made therein without departing from the scope of the present invention as defined by the claims. For example, the above-mentioned embodiments have exemplified quasi-synchronous detection in which the carrier recovery circuit is formed of only digital circuits, but this invention is naturally applicable also to a synchronous detection circuit formed of an analog LO oscillator and an analog quadrature demodulator. Further, the clock synchronization circuit described above uses an analog voltage-controlled oscillator, but this invention is applicable also to the case where the clock synchronization circuit is formed of only digital circuits similarly to the carrier recovery circuit. In this case, an A/D converter performs sampling in response to an asynchronous clock signal, and a digital circuit compensates for the phase difference.

### Industrial Applicability

This invention is used in a wireless communication system for millimeter waves or microwaves, in which the phase noise level of a LO signal is high and which employs a multilevel QAM modulation scheme and a high-gain error correction scheme. The device to which this invention is applicable is not limited to a wireless system. Also in a wired system that distributes a digital TV signal through a cable, phase noise of a tuner for frequency conversion is a problem in realizing a higher capacity by multilevel modulation. This invention is effective also for such a wired system.

## Claims

1. A clock synchronization circuit (30) to be used in a 2ⁿ-QAM demodulator, where n is an integer of 4 or more, the clock synchronization circuit (30) comprising:
a voltage-controlled oscillator (35) for producing a sampling clock signal in accordance with a control signal;
an A/D converter (31) for converting an analog base band signal, which has been converted into a base band by a quadrature demodulator, into a digital signal in synchronization with the sampling clock signal;
a phase error detector (32) for extracting, from the digital signal, a phase error corresponding to an optimum sampling phase of the analog base band signal and the sampling clock signal to produce a phase error signal corresponding to a value of the phase error;
a limiter circuit (33) for limiting an expression range of the phase error signal to a constant value or less to produce the limited phase error signal; and
a loop filter for producing, based on the limited phase error signal, the control signal so that the phase of the sampling clock signal matches with the optimum phase, to thereby determine frequency characteristics of a loop.

2. A demodulator of a multilevel quadrature amplitude modulation scheme, which uses the clock synchronization circuit according to claim 1.

3. A method for clock synchronization of a demodulator, comprising:
producing a sampling clock signal in accordance with a control signal;
converting an analog base band signal, which has been converted into a base band by a quadrature demodulator, into a digital signal in synchronization with the sampling clock signal;
extracting, from the digital signal, a phase error corresponding to an optimum sampling phase of the analog base band signal and the sampling clock signal;
producing a phase error signal corresponding to a value of the phase error;
limiting an expression range of the phase error signal to a constant value or less to produce the limited phase error signal; and
producing, based on the limited phase error signal, the control signal so that the phase of the sampling clock signal matches with the optimum phase, to thereby determine frequency characteristics of a loop.

## Patentansprüche

1. Taktsynchronisationsschaltung (30) zur Verwendung in einem 2ⁿ-QAM-Demodulator, wobei n eine ganze Zahl von 4 oder mehr ist, wobei die Taktsynchronisationsschaltung (30) aufweist:
einen spannungsgesteuerten Oszillator (35) zur Erzeugung eines Tasttaktsignals in Übereinstimmung mit einem Steuersignal,
einen A/D-Konverter (31) zum Wandeln eines analogen Basisbandsignals, das durch einen Quadraturdemodulator in ein Basisbandsignal gewandelt wurde, in ein digitales Signal synchron mit dem Tasttaktsignal,
einen Phasenfehlerdetektor (32) zum Extrahieren aus dem Digitalsignal eines Phasenfehlers, der mit einer optimalen Tastphase des analogen Basisbandsignals und dem Tasttaktsignal korrespondiert, um ein Phasenfehlersignal entsprechend einem Wert des Phasenfehlers zu erzeugen,
einer Begrenzerschaltung (33) zum Begrenzen eines Ausdrucksbereichs des Phasenfehlersignals auf einen konstanten Wert oder weniger, um das begrenzte Phasenfehlersignal zu erzeugen, und
einen Schleifenfilter zum Erzeugen, basierend auf dem begrenzten Phasenfehlersignal, des Steuersignals derart, dass die Phase des Tasttaktsignal der optimalen Phase entspricht, um dadurch die Frequenzcharakteristika einer Schleife zu bestimmen.

2. Demodulator eines Mehrfachpegel-Quadraturamplituden-Modulationsschemas, der die Taktsynchronisationsschaltung nach Anspruch 1 verwendet.

3. Verfahren zur Taktsynchronisation eines Demodulators mit:
Erzeugen eines Tasttaktsignals in Übereinstimmung mit einem Steuersignal,
Wandeln eines analogen Basisbandsignals, das durch einen Quadraturdemodulator in ein Basisband gewandelt wurde, in ein Digitalsignal synchron mit dem Tasttaktsignal,
Extrahieren eines Phasenfehlers entsprechend einer optimalen Tastphase des analogen Basisbandsignals und dem Tasttaktsignal aus dem Digitalsignal,
Erzeugen eines Phasenfehlersignals entsprechend einem Wert des Phasenfehlers,
Begrenzen eines Ausdrucksbereichs des Phasenfehlersignals auf einen konstanten Wert oder weniger, um das begrenzte Phasenfehlersignal zu erzeugen, und
Erzeugen des Steuersignals basierend auf dem begrenzten Phasenfehlersignal derart, dass die Phase des Tasttaktsignals der optimalen Phase entspricht, um dadurch die Frequenzcharakteristika einer Schleife zu bestimmen.

## Revendications

1. Circuit de synchronisation d'horloge (30) à utiliser dans un 2ⁿ démodulateur MAQ, où n est un entier de 4 ou plus, le circuit de synchronisation d'horloge (30) comprenant :
un oscillateur régulé en tension (35) pour produire un signal d'horloge d'échantillonnage en conformité avec un signal de commande ;
un convertisseur A/N (31) pour convertir un signal de bande de base analogique, qui a été converti en bande de base par un démodulateur en quadrature, en un signal numérique en synchronisation avec le signal d'horloge d'échantillonnage ;
un détecteur d'erreur de phase (32) pour extraire, à partir du signal numérique, une erreur de phase correspondant à une phase d'échantillonnage optimale du signal de bande de base analogique et du signal d'horloge d'échantillonnage pour produire un signal d'erreur de phase correspondant à une valeur de l'erreur de phase ;
un circuit limiteur (33) pour limiter une plage d'expression du signal d'erreur de phase à une valeur constante ou moins afin de produire le signal d'erreur de phase limité ; et
un filtre à boucle pour produire, d'après le signal d'erreur de phase limité, le signal de commande de sorte que la phase du signal d'horloge d'échantillonnage concorde avec la phase optimale, afin de déterminer ainsi des caractéristiques de fréquence d'une boucle.

2. Démodulateur d'un schéma de modulation d'amplitude en quadrature multiniveau, qui utilise le circuit de synchronisation d'horloge selon la revendication 1.

3. Procédé de synchronisation d'horloge d'un démodulateur, comprenant :
la production d'un signal d'horloge d'échantillonnage en conformité avec un signal de commande ;
la conversion d'un signal de bande de base analogique, qui a été converti en bande de base par un démodulateur en quadrature, en un signal numérique en synchronisation avec le signal d'horloge d'échantillonnage ;
l'extraction, à partir du signal numérique, d'une erreur de phase correspondant à une phase d'échantillonnage optimale du signal de bande de base analogique et du signal d'horloge d'échantillonnage ;
la production d'un signal d'erreur de phase correspondant à une valeur de l'erreur de phase ;
la limitation d'une plage d'expression du signal d'erreur de phase à une valeur constante ou moins afin de produire le signal d'erreur de phase limité ; et
la production, d'après le signal d'erreur de phase limité, du signal de commande de sorte que la phase du signal d'horloge d'échantillonnage concorde avec la phase optimale, afin de déterminer ainsi des caractéristiques de fréquence d'une boucle.
